# EUROPEAN PATENT APPLICATION

(11) **EP 1 387 603 A1**
(43) Date of publication of application: **04.02.2004**
(21) Application number: 02255317.6
(22) Date of filing: 30.07.2002
(51) Int. Cl.: H05K 3/34, H05K 1/18

(54) **Electronic assembly and method of manufacture thereof**

(71) Applicant: Agilent Technologies, Inc. - a Delaware corporation -, Palo Alto, CA 94303-0870 (US)
(72) Inventor: Bardsley, Richard, Andover, Hampshire SP10 2JQ (GB)
(74) Representative: Coker, David Graeme

(57) **Abstract**

The assembly of surface mount components (SMCs) upon a printed circuit board (PCB) substrate is hindered by the limited space available upon the PCB due to the requirement of two solder pads per assembled component and by a process known as tombstoning where one end of an SMC may become dislocated from the PCB during the assembly process causing broken electrical connections between the solder pads and therefore inoperability of the PCB. The present invention therefore provides an electronic assembly (8) wherein the components are mounted substantially perpendicular to a PCB upon a single conductive region (12) and comprise means (18, 20) for connecting the component (10) to a neighbouring electrical device (24).

## Description

The present invention relates to an electronic assembly and to a method of manufacture of the electronic assembly of a type, for example, comprising an electrical component mounted upon a circuit board and having a connection to a neighbouring electrical device such as an integrated circuit.

In the field of surface mount technology, in order to manufacture an electronic assembly, an electrical component, for example a Surface Mount Component (SMC) is known to be mounted on a circuit board, such as a Printed Circuit Board (PCB). In order to mount the SMC upon the PCB, the PCB is provided with a pair of adjacent, spaced, conductive regions on the PCB whereupon an amount of solder paste is deposited, for example, by screen printing in order to provide a pair of solder pads. One or both solder pads can be connected by a metal trace to a bonding pad having a soft gold plated finish in order to facilitate a wire bond connection to a neighbouring electrical device such as an integrated circuit, another SMC or the PCB.

To mount the component upon the PCB, the component is placed upon the PCB ensuring that a first terminal corresponding to a first end of the component and a second terminal corresponding to a second end of the component are aligned upon the adjacent solder pads in contact with the solder paste so as to bridge the gap between the adjacent bonding pads; a technique known as mounting the component horizontally.

To fix the component to the PCB, the solder paste undergoes a heating stage using, for example, a known solder reflow process to liquefy the solder paste and to cause the liquefied solder to "wick up" the terminals of the component. The liquefied solder paste then undergoes a curing stage in order to cause the solder paste to fix to the terminals of the component and to the solder pads, thereby providing both an electrical and mechanical connection between the PCB and the component.

Following mounting of the component upon the PCB, in order to connect the component to the neighbouring electrical device, a first end of the wire bond is coupled to the bonding pad and a second end of the wire bond is coupled to, for example, a contact pad of the integrated circuit in order to complete the connection between the component and the integrated circuit as part of the provision of the electronic assembly.

The above method of manufacturing an electronic assembly is disadvantageous for a number of reasons. Firstly, two solder pads are required for mounting of one component upon a PCB and the solder pads cover a larger surface area (in the region of 30% more per solder pad) than the surface area of the respective terminals of the component aligned and disposed thereupon. The larger surface area of the solder pads is required to accommodate the surface area of the solder paste as the solder paste becomes liquefied during the heating stage so as to prevent the liquefied solder paste encroaching onto the bonding pad or onto parts of the PCB where solder is unwanted. Should any liquefied solder paste encroach onto the bonding pad it can lead to a reduced area of soft gold plated finish available for facilitating the wire bond connection. The metal trace connecting the solder pad and the bonding pad can also be covered with solder resist to prevent any encroachment of solder paste onto the bonding pad. Should any liquefied solder paste encroach onto other parts of the PCB it may contact adjacent components or other conductive regions of the PCB and cause a short circuit thereby causing inefficient operation of the PCB, or even render the PCB inoperable. Solder pads clearly use valuable component "real estate" on the PCB which could otherwise be used for siting additional components. Presently, in order to increase the number of components mounted on a PCB, research and development is focused on the miniaturisation of the components themselves.

Secondly, it is known that during the heating stage, as the solder paste becomes liquefied, surface tension is exerted at the interface between the terminals of the component and the liquefied solder paste. Should the surface tension between two terminals of one component be unequal during the heating stage, an imbalance of forces can cause one end of the component to become dislocated from its respective solder pad whilst the other end begins to adhere to the liquefied solder paste, which during the curing stage, bonds rigidly to its respective solder pad.

Such an imbalance in forces can lead to a phenomenon occurring known as "tombstoning" where rotational forces can cause the component to rise into a substantially perpendicular position with respect to the PCB, i.e. the component "stands up" on one end. Consequently, on inspection of the PCB following the curing stage, many components may have broken electrical connections upon the PCB causing inoperability of the PCB.

Tombstoning is therefore considered as a hindrance in the field of surface mount technology and much research and development is directed toward its prevention. It is also known that as smaller components are manufactured the problems associated with tombstoning and its frequency of occurrence increase.

According to a first aspect of the present invention, there is provided a method of manufacture of an electronic assembly, the electronic assembly comprising a circuit board and an electrical component, the method comprising the steps of: laying a first terminal of the electrical component upon a conductive region of the circuit board, and providing solder paste contacting the first terminal of the component and the circuit board; the method being characterised by the steps of: heating the solder paste so as to liquefy the solder paste thereby permitting a second terminal of the component to rise above the first terminal so as to erect the component substantially perpendicular to the conductive region; curing the liquefied solder paste in order to fix the first terminal of the component to the conductive region of the circuit board.

Preferably, the method of manufacture further comprises the step of electrically connecting the second terminal of the component to a first terminal of an electrical device.

According to a second aspect of the present invention, there is provided an electronic assembly comprising: a conductive region, and an electrical component having a first terminal at a first end and a second terminal at a second end, the first terminal being fixed to the conductive region and the second terminal being disposed substantially perpendicular to the conductive region; characterised in that: the second terminal is arranged to receive connecting means for facilitating an electrical connection between the component and an electronic device.

Preferably, the second terminal of the component is gold plated.

Preferably, the connecting means is a wire bond.

Preferably, the electronic device is an integrated circuit. More preferably, the electronic device is an electrical component.

According to a third aspect of the present invention, there is provided an advantageous use of tombstoning in a method of manufacture of an electronic assembly.

It should be appreciated that prior to laying a component upon a circuit board the solder paste may be deposited on a conductive region of the circuit board, on a terminal of the component or deposited on both a conductive region of the circuit board and a terminal of the component.

The present invention therefore provides significant space saving upon a PCB because the component is mounted substantially perpendicular to the PCB and, as opposed to parallel to the PCB as is known in the art, thereby only requiring one solder pad/conductive region per component. Each component requires less real estate and additional components may therefore be mounted upon the PCB increasing the functionality and efficiency of the electronic assembly. Furthermore, because the wire bond is coupled to the second terminal of the component and not to a bonding pad, one less electrical connection and bonding pad is needed per component thereby increasing efficiency and performance of the PCB in addition to reducing manufacturing costs incurred in its production.

At least one embodiment of the present invention will now be described, by way of example only, with reference to the accompanying drawings, in which:
Figure 1 is a schematic diagram of an electronic assembly according to a first embodiment of the present invention; and
Figure 2 is a flow diagram of a method of manufacture of the electronic assembly of Figure 1.

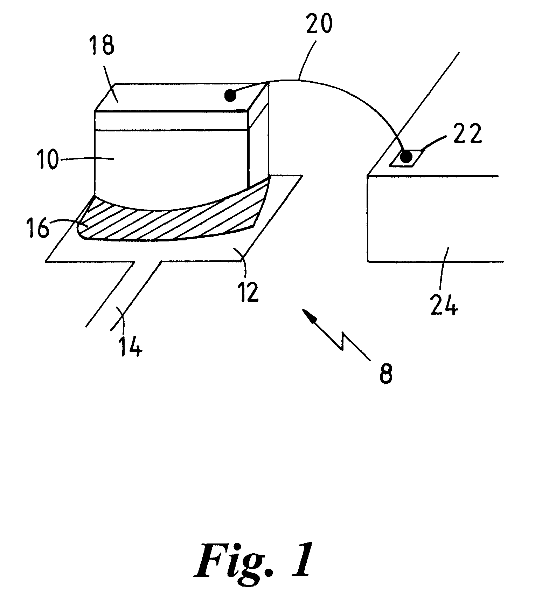

Referring to Figure 1, an electronic assembly 8 comprises an electrical component 10, for example a capacitor, mounted upon a conductive region 12 of a circuit board (not shown) such as a Printed Circuit Board (PCB). The component 10 is disposed substantially perpendicular to the PCB. The conductive region 12 comprises a connecting track 14 coupled to, for example, other such mounted components (not shown) upon the PCB.

A cured solder paste 16 communicates between the conductive region 12 and a first end of the component 10 corresponding to a first metallised terminal (not shown) of the component 10. A second end of the component 10 corresponding to a second terminal 18 of the component 10 is adapted to receive a first end of a wire bond 20 and can be soft gold plated. A second end of the wire bond 20 is coupled to a connecting pad 22 of a neighbouring electronic device such as an integrated circuit 24 also disposed upon the PCB and adjacent the component 10. It should be appreciated that the neighbouring electronic device may be also be an electrical component such as a capacitor, resistor, transistor, grounding means, or compatible electronic device or circuit known in the art.

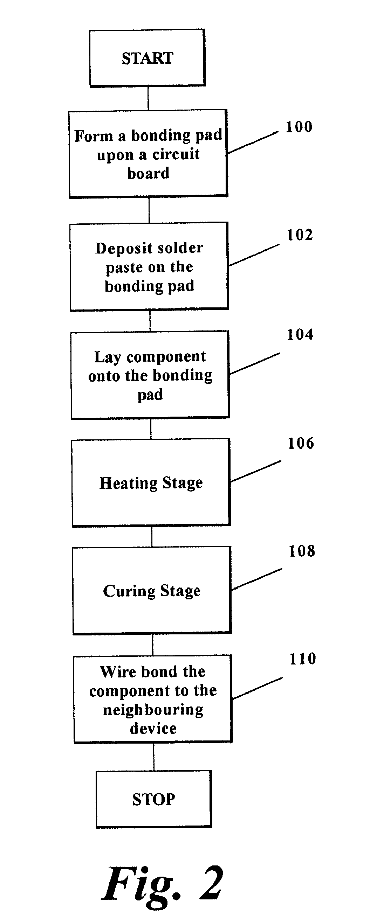

Referring to Figure 2, a method of manufacture of the electronic assembly 8 is as follows. The conductive region 12 of the PCB is formed as part of the PCB using any suitable technique known in the art (Step 100). For the purposes of the invention, it is only important to recognise that the conductive region 12 is required, the generation of the conductive region 12 is irrelevant for the purposes of understanding and reproducing the invention. The conductive region 12 should be of a large enough size to accommodate enough solder to provide the required surface tension to erect the component 10 during solder reflow. For example, a pad size of 0.64mm² can be employed and coated with solder paste, such as Multicore type 25G (SN62RM10BAS86), to a thickness of 0.3mm.

An amount of solder paste 16 is deposited upon the conductive region 12 using suitable techniques known in the art, such as by screen printing (Step 102) to form a suitable solder pad. The electrical component 10 is laid upon the PCB such that the first end corresponding to the first terminal of the component 10 is placed upon the solder paste 16 deposited upon the conductive region 12 (Step 104) and the second end corresponding to the second terminal 18 of the component 10 lies upon the PCB, but not on a conductive region 12 covered with solder paste.

In order to fix the component 10 to the conductive region 12, and therefore create a mechanical and electrical connection to the PCB, the solder paste 16 is subjected to a heating stage (Step 106) by, for example, infrared reflow heating of the PCB comprising the arranged component 10 in order to liquefy the solder paste 16. During the heating stage (Step 106) of the solder reflow process, the solder paste 16 becomes liquefied and surface tension at the interface of the liquefied solder paste 16 with the first terminal of the component 10 causes the solder paste 16 to adhere to the first terminal , whilst also causing the second terminal 18 of the component 10 to rise above the first terminal so as to erect the component 10 substantially perpendicular to the PCB. During the curing stage (Step 108) of the solder reflow process the first terminal fixes to the solder paste 16 and creates a mechanical and electrical connection with the PCB.

On completion of the curing stage (Step 108), the first end of the wire bond 20 is coupled to the second terminal of the component 10 (which is soft gold plated) and the second end of the wire bond 20 is coupled to the contact pad 22 of the integrated circuit 24 in order to complete manufacture of the electronic assembly 8 (Step 110).

## Claims

1. A method of manufacture of an electronic assembly (8), the electronic assembly (8) comprising a circuit board and an electrical component (10), the method comprising the steps of:
laying a first terminal of the electrical component (10) upon a conductive region (12) of the circuit board, and providing solder paste (16) contacting the first terminal of the component (10) and the circuit board;
the method being **characterised by** the steps of: heating the solder paste (16) so as to liquefy the solder paste (16); thereby permitting a second terminal (18) of the component (10) to rise above the first terminal so as to erect the component (10) substantially perpendicular to the conductive region (12);
curing the liquefied solder paste (16) in order to fix the first terminal of the component (10) to the conductive region (12) of the circuit board.

2. A method according to Claim 1 further comprising the step of:
electrically connecting the second terminal (18) of the component (10) to a first terminal of an electrical device (24).

3. A method as claimed in any one of the preceding claims, wherein the second terminal (18) of the component (10) is gold plated.

4. A method as claimed in Claim 2 or Claim 3, wherein the electronic device (24) is an integrated circuit.

5. A method as claimed in Claim 2 or Claim 3, wherein the electronic device (24) is an electrical component.

6. An electronic assembly (8) comprising a conductive region (12), and an electrical component (10) having a first terminal at a first end and a second terminal (18) at a second end, the first terminal being fixed to the conductive region (12) and the second terminal (12) being disposed substantially perpendicular to the conductive region;
**characterised in that**:
the second terminal (12) is arranged to receive connecting means (20) for facilitating an electrical connection between the component (10) and an electronic device (24).

7. An electronic assembly (8) as claimed in Claim 6, wherein the second terminal (18) of the component (10) is gold plated.

8. An electronic assembly (8) as claimed in Claim 6 or Claim 7, wherein the connecting means (20) is a wire bond.

9. An electronic assembly (8) as claimed in any one of the claims 6 to 8, wherein the electronic device (24) is an integrated circuit or an electrical component.

10. A use of tombstoning in a method of manufacture of an electronic assembly (8).
